# FASCICULE DE BREVET EUROPEEN

(11) **EP 2 792 220 B1**
(45) Date de publication et mention de la délivrance du brevet: **18.01.2017**
(21) Numéro de dépôt: 12816702.0
(22) Date de dépôt: 10.12.2012
(51) Int. Cl.: C25D 11/00, H05K 1/02, H01L 23/367, H05K 3/00

(54) **LIAISON THERMIQUEMENT CONDUCTRICE ET ÉLECTRIQUEMENT ISOLANTE ENTRE AU MOINS UN COMPOSANT ÉLECTRONIQUE ET UN RADIATEUR EN TOUT OU PARTIE MÉTALLIQUE**
THERMISCH LEITENDE UND ELEKTRISCH ISOLIERENDE VERBINDUNG ZWISCHEN ZUMINDEST EINEM ELEKTRONISCHEN BAUTEIL UND EINEM GANZ ODER TEILS METALLSICHEN KÜHLKÖRPER
LIAISON THERMALLY CONDUCTIVE AND ELECTRICALLY INSULATING CONNECTION BETWEEN AT LEAST ONE ELECTRONIC COMPONENT AND AN ALL OR PARTIALLLY METALLIC HEAT SINK

(30) Priorité: 15.12.2011 FR 1161692
(43) Date de publication de la demande: 22.10.2014
(73) Titulaire: Valeo Systèmes de Contrôle Moteur, 95800 Cergy (FR)
(72) Inventeur: BENDANI, Larbi, F-60110 Meru (FR); ASKEUR, Mimoun, F-95490 Vaureal (FR); DELAPORTE, Francis, 95450 FREMAINVILLE (FR)
(74) Mandataire: Novembre, Christophe Adelphe
(86) Numéro de dépôt international: PCT/FR2012/052862
(87) Numéro de publication internationale: WO 2013/088047

(56) Documents cités:
- EP-A2- 2 023 706
- DE-A1- 10 349 775
- US-A- 5 075 759
- US-B1- 6 449 158

## Description

La présente invention concerne la réalisation d'une liaison thermiquement conductrice et électriquement isolante entre au moins un composant électronique et un radiateur. Au sens de l'invention, il faut comprendre par « liaison électriquement isolante » une liaison qui assure la continuité des signaux électriques et leur isolement. « Isolant électriquement » est défini selon la norme IPC TM650.

Toujours au sens de l'invention, une liaison est thermiquement conductrice lorsqu'elle présente une résistance thermique d'une valeur comprise entre 1.5°C/W et 3.5°C/W pour des puissances de 10W à 20W.

De façon générale, pour mesurer la résistance thermique d'un circuit imprimé, on peut braser sur ce circuit imprimé un transistor MOS et injecter un courant dans la diode interne de ce transistor. La mesure de tension de part et d'autre de ce circuit imprimé donne, à partir des spécifications du circuit imprimé communiquées par le fabricant, la variation de température.

Connaissant la résistance thermique du circuit imprimé, on peut, en procédant de la même façon pour un ensemble comprenant le circuit imprimé et le support, mesurer la tension de part et d'autre de cet ensemble. On en déduit la résistance thermique de l'ensemble, et par différence avec la résistance thermique du circuit imprimé, la résistance thermique du support.

L'invention s'applique notamment mais non exclusivement pour des composants électroniques étant des interrupteurs de puissance faisant partie d'un onduleur. Cet onduleur appartient par exemple à un circuit onduleur/chargeur comprenant en outre un moteur électrique et intégré à un véhicule électrique ou hybride.

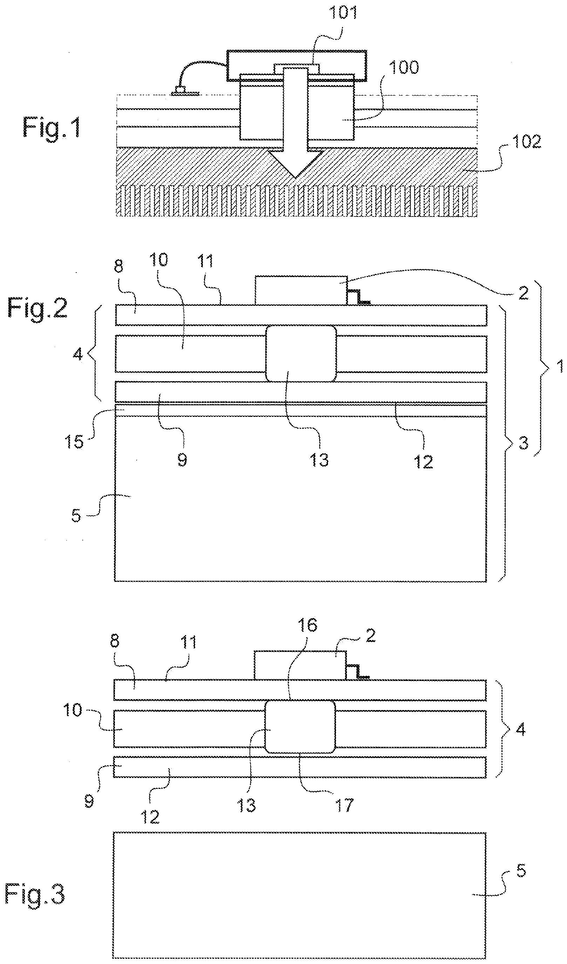

Le composant électronique et le radiateur font partie d'un ensemble comprenant un circuit imprimé à travers lequel la chaleur dissipée par le composant électronique est transférée vers le radiateur. Il est connu, comme représenté par exemple sur la figure 1, d'introduire dans le circuit imprimé un insert métallique 100, par exemple réalisé en cuivre, et favorisant le transfert de la chaleur dégagée par le composant électronique 101 vers le radiateur 102. Lorsque le composant électronique 101 est alimenté par une haute tension et/ou par des courant importants, la chaleur qu'il dégage est plus importante et le besoin en isolation électrique entre le composant électronique 101 et le radiateur 102 augmente.

La demande EP 2 023 706 enseigne d'anodiser une couche d'un insert disposé entre un radiateur et un composant électronique. L'insert s'étend au-delà d'un circuit imprimé vers le radiateur.

Le brevet US 6 449 158 enseigne de disposer dans une cavité d'un circuit imprimé un composant électronique et d'interposer une couche d'aluminium anodisé entre ce composant électronique et un radiateur. Le composant électronique n'est alors pas porté par une face extérieure du circuit imprimé.

Il existe un besoin pour permettre un bon transfert de la chaleur dégagée par le composant électronique vers le radiateur tout en garantissant une isolation électrique satisfaisante entre le radiateur et le composant électronique.

L'invention a pour but de répondre à ce besoin et elle y parvient, selon l'un de ses aspects, à l'aide d'un procédé de réalisation d'une liaison thermiquement conductrice et électriquement isolante entre au moins un composant électronique et un radiateur en tout ou partie métallique, le composant électronique et le radiateur faisant partie d'un ensemble comprenant en outre un circuit imprimé disposé entre le composant électronique et le radiateur, le circuit imprimé comprenant au moins une couche métallique et un insert métallique,
procédé dans lequel on anodise au moins une surface métallique à travers laquelle la chaleur est dissipée du composant électronique vers le radiateur, ladite surface métallique appartenant à l'un du composant électronique, du circuit imprimé et du radiateur.

L'insert peut être exclusivement contenu dans la hauteur du circuit imprimé, c'est-à-dire que l'insert ne fait alors saillie au-delà du circuit imprimé ni vers le radiateur, ni vers le composant électronique.

Le circuit imprimé peut être exclusivement disposé entre le composant électronique et le radiateur, c'est-à-dire que, lorsque le radiateur, le circuit imprimé et le composant électronique sont empilés selon un axe dans cet ordre, il n'existe pas de plan perpendiculaire à cet axe et coupant à la fois le radiateur et le circuit imprimé, ou à la fois le circuit imprimé et le composant électronique.

Le composant électronique est par exemple porté par une face du circuit imprimé qui définit une surface de réception pour ce composant. Dans ce qui suit, « face du circuit imprimé » désigne une face extérieure de ce dernier.

Selon l'invention, seule une anodisation surfacique peut être réalisée, ce qui n'est par exemple pas le cas selon le brevet US 6 449 158 dans lequel une anodisation totale d'une couche d'aluminium est réalisée.

L'anodisation de cette ou ces surfaces permet d'assurer une isolation électrique sans pour autant entraver le transfert de chaleur du composant électronique vers le radiateur à travers ladite surface. En outre, la réalisation de cette isolation électrique par anodisation s'effectue à un coût réduit.

Le composant électronique peut comprendre un boîtier ayant au moins une partie métallique, ledit boîtier reposant sur une surface de réception du circuit imprimé via ladite partie métallique, et ladite partie métallique du boîtier peut être anodisée. Cette surface anodisée du boîtier fournit alors la ou l'une des surfaces métalliques anodisées de l'ensemble.

Le radiateur peut présenter une surface métallique en contact avec le circuit imprimé et ladite surface du radiateur peut être anodisée. Cette surface anodisée du radiateur fournit alors la ou l'une des surfaces métalliques anodisées. Le radiateur est par exemple réalisé en tout ou partie en aluminium, ce matériau présentant des propriétés électriques et thermiques satisfaisantes tout en étant d'un coût et d'un poids réduits.

Le radiateur peut être réalisé d'une seule pièce, auquel cas une partie de cette pièce est soumise à un traitement d'anodisation. En variante, on rapporte sur le radiateur une pièce préalablement anodisée et une surface de cette pièce rapportée constitue la surface métallique anodisée du radiateur.

L'insert métallique peut être réalisé d'un seul tenant, étant par exemple réalisé d'une seule pièce.

L'insert métallique peut être en cuivre.

Selon un premier mode de mise en oeuvre de l'invention, l'insert métallique est noyé dans le reste du circuit imprimé. Le circuit imprimé comprend selon ce premier mode de mise en oeuvre au moins deux couches métalliques, la première couche métallique est interposée entre l'insert métallique et le composant électronique et la deuxième couche métallique est interposée entre l'insert métallique et le radiateur. Chacune des couches métalliques peut être réalisée en cuivre.

Selon une première variante de ce premier mode de mise en oeuvre, la face de la première couche métallique en regard du composant électronique est en tout ou partie anodisée. Cette face anodisée de la première couche métallique fournit alors la ou l'une des surfaces métalliques anodisées de l'ensemble.

Selon une deuxième variante de ce premier mode ou en combinaison de la première variante ci-dessus, la face de la deuxième couche métallique en regard du radiateur est en tout ou partie anodisée. Cette face anodisée de la deuxième couche métallique fournit alors la ou l'une des surfaces métalliques anodisées de l'ensemble.

Selon une autre variante du premier mode de mise en oeuvre de l'invention, ou le cas échéant selon la première ou la deuxième variante ci-dessus, l'insert métallique peut présenter une première face de contact avec une surface de contact correspondante de la première couche métallique et une deuxième face de contact avec une surface de contact correspondante de la deuxième couche métallique, et l'une au moins des surfaces suivantes peut être anodisée :
- ladite première face de contact,
- ladite surface de contact correspondante de la première couche métallique,
- ladite deuxième face de contact, et
- ladite surface de contact correspondante de ladite deuxième couche métallique.

Cette surface anodisée fournit ainsi la ou l'une des surfaces métalliques anodisées de l'ensemble.

Le cas échéant, la chaleur dégagée par le composant électronique peut être dissipée à travers plusieurs surfaces métalliques anodisées.

Selon un deuxième mode de mise en oeuvre de l'invention, l'insert métallique peut ne pas être noyé dans le reste du circuit imprimé.

Le circuit imprimé peut comprendre deux couches métalliques, par exemple en cuivre, ainsi qu'une couche en prépreg et une cavité peut être ménagée à travers ces couches.

La couche de prépreg peut représenter entre 20 et 90% de l'épaisseur du circuit imprimé, par exemple entre 50% et 80%.

L'insert métallique est par exemple disposé dans cette cavité, étant notamment monté à force dans celle-ci, et présente une face de contact avec le composant électronique. Cette face de contact de l'insert métallique peut être anodisée, fournissant alors la ou l'une des surfaces métalliques anodisées de l'ensemble.

Selon ce deuxième mode de mise en oeuvre, lorsque l'insert est disposé dans la cavité traversante, il peut ne pas s'étendre dans l'épaisseur de la deuxième couche métallique et la partie de la cavité ménagée dans cette deuxième couche métallique peut être comblée en tout ou partie par une résine. La deuxième couche métallique peut être une couche d'extrémité du circuit imprimé, une face de la deuxième couche métallique formant alors une face d'extrémité du circuit imprimé et la résine peut être disposée dans la cavité de manière à ce que ladite face d'extrémité du circuit imprimé soit sensiblement plane, y compris au niveau de la cavité.

En variante, l'insert ne s'étend pas dans l'épaisseur de la première couche métallique mais dans la couche en prépreg et la deuxième couche métallique et la partie de la cavité ménagée dans la première couche métallique est comblée en tout ou partie par une résine, comme décrit ci-dessus en rapport avec la deuxième couche métallique, notamment en ce qui concerne l'obtention d'une surface plane.

En variante encore, l'insert ne s'étend que dans une partie de l'épaisseur de la première couche métallique ou de la deuxième couche métallique et la partie de la cavité non occupée par l'insert dans la première ou la deuxième couche métallique est comblée en tout ou partie par la résine. Des surfaces planes peuvent être obtenues comme indiqué ci-dessus.

A part selon le premier mode de mise en oeuvre de l'invention, l'insert métallique peut présenter une face de contact avec le radiateur et ladite face de contact de l'insert peut être anodisée. La face anodisée de l'insert, qui appartient au circuit imprimé, fournit alors la ou l'une des surfaces métalliques anodisées de l'ensemble.

L'invention a encore pour objet, selon un autre de ses aspects, un ensemble comprenant :
- au moins un composant électronique,
- un radiateur en tout ou partie métallique et,
- un circuit imprimé disposé entre le radiateur et le composant électronique, ledit circuit imprimé comprenant au moins une couche métallique et un insert métallique,
l'un au moins du composant électronique, du circuit imprimé et du radiateur comprenant au moins une surface métallique à travers laquelle la chaleur dissipée par le composant électronique est transférée vers le radiateur, ladite surface métallique étant anodisée.

L'ensemble ci-dessus permet d'obtenir les avantages déjà mentionnés ci-dessus.

L'insert peut être disposé entre le composant électronique et le radiateur.

Tout ou partie des caractéristiques présentées en rapport avec le procédé ci-dessus peuvent être combinées avec l'ensemble tel que défini ci-dessus.

Le composant électronique est par exemple un composant électronique présentant une puissance nominale supérieure à 1kW. La puissance thermique dissipée par ce composant lorsqu'il est alimenté électriquement peut être comprise entre 10W et 50W, par exemple.

Ce composant fait par exemple partie d'un onduleur d'un circuit onduleur/chargeur comprenant en outre un moteur électrique et intégré à un véhicule hybride ou électrique.

L'invention a encore pour objet, selon un autre de ses aspects, une structure pour au moins un composant électronique, la structure comprenant :
- un circuit imprimé dont une face définit une surface de réception de composant électronique, le circuit imprimé comprenant un insert métallique, et
- un radiateur en tout ou partie métallique, le radiateur ayant une surface anodisée en regard du circuit imprimé.

Le radiateur est par exemple en aluminium, auquel cas l'anodisation permet qu'une couche d'alumine soit au contact du circuit imprimé.

L'invention a encore pour objet, selon un autre de ses aspects, une structure pour au moins un composant électronique, la structure comprenant :
- un circuit imprimé dont une face définit une surface de réception de composant électronique, le circuit imprimé comprenant un insert métallique et au moins une couche métallique, et
- un radiateur, le radiateur ayant une surface en regard du circuit imprimé, l'insert métallique étant noyé dans le reste du circuit imprimé et comprenant une face de contact avec une surface de contact correspondante de la couche métallique du circuit imprimé.

L'invention a encore pour objet, selon un autre de ses aspects, une structure pour au moins un composant électronique, la structure comprenant :
- un circuit imprimé dont une face définit une surface de réception de composant électronique, le circuit imprimé comprenant un insert métallique, et
- un radiateur, le radiateur ayant une surface en regard du circuit imprimé, l'insert métallique étant disposé dans une cavité traversante ménagée dans le circuit imprimé de manière à ce qu'une portion dudit insert forme une partie de la surface de réception de composant électronique, ladite portion de l'insert étant anodisée.

L'invention pourra être mieux comprise à la lecture de la description qui va suivre d'exemples non limitatifs de mise en oeuvre de celle-ci et à l'examen du dessin annexé sur lequel :
- la figure 1 représente un exemple d'ensemble selon l'art antérieur déjà décrit,
- la figure 2 représente de façon schématique un ensemble selon une variante d'un premier mode de mise en oeuvre de l'invention,
- les figures 3 et 4 représentent de façon schématique d'autres variantes du premier mode de mise en oeuvre de l'invention,
- la figure 5 représente de façon schématique un ensemble selon une variante d'un second mode de mise en oeuvre de l'invention, et
- les figures 6 et 7 représentent de façon schématique d'autres variantes du second mode de mise en oeuvre de l'invention.

On a représenté à la figure 2 un ensemble 1 selon un premier mode de mise en oeuvre de l'invention. Cet ensemble 1 comprend un composant électronique 2, par exemple un transistor de puissance tel qu'un transistor à effet de champ, et une structure 3 sur laquelle est rapporté, par exemple par brasure, le composant 2. Le composant 2 présente par exemple une puissance nominale supérieure ou égale à 1kW et dégage, lorsqu'il est alimenté électriquement, une puissance thermique comprise entre 10W et 50W. Le composant électronique 2 peut supporter une tension de l'ordre de 430V et un courant de l'ordre de 13A.

La structure 3 comporte dans l'exemple représenté un circuit imprimé 4 et un radiateur 5, le radiateur étant notamment en aluminium.

Le circuit imprimé 4 se présente dans l'exemple considéré sous une forme multicouche, comprenant une première couche en cuivre 8, une deuxième couche en cuivre 9 et une couche en prépreg 10 emprisonnée entre les couches en cuivre 8 et 9.

La première couche en cuivre 8 présente une face 11 définissant une surface de réception du circuit imprimé sur laquelle est rapporté le composant électronique 2.

La deuxième couche en cuivre 9 présente une face 12 en regard du radiateur 5 qui définit une autre surface d'extrémité pour le circuit imprimé 4.

Comme représenté, la couche en prépreg 10 peut présenter une épaisseur supérieure à celle de chaque couche en cuivre 8 ou 9.

Le circuit imprimé 4 comprend en outre un insert métallique 13, par exemple en cuivre. Dans l'exemple de la figure 2, l'insert 13 est reçu dans une cavité ménagée à travers la couche en prépreg 10 uniquement, n'étant pas reçu dans l'épaisseur des couches en cuivre 8 et 9. L'insert 13 est disposé vis-à-vis du composant électronique 2 et du radiateur 5 de manière à ce que la chaleur dissipée par ce composant 2 transite via l'insert 13 vers le radiateur 5.

Le circuit imprimé 4 représenté sur la figure 2 est par exemple commercialisé par la société Schweizer Electronic™ sous la référence FR4 6L Insert In-LAY.

Dans l'exemple de la figure 2, la surface d'extrémité 12 du circuit imprimé est au contact d'une surface anodisée 15 du radiateur 5. Cette surface anodisée 15 est par exemple obtenue par anodisation d'une portion du bloc métallique formant le radiateur 5.

En variante, une pièce métallique, par exemple en aluminium, est préalablement anodisée avant d'être rapportée sur le radiateur 5 afin de définir la surface de contact du radiateur avec le circuit imprimé 4.

Cette surface anodisée 15 permet d'établir une isolation électrique satisfaisante entre le composant électronique 2 et le radiateur 5, sans nuire à la dissipation de chaleur du composant électronique 2 vers le radiateur 5. On obtient ainsi une liaison entre le composant électronique 2 et le radiateur 5 qui est isolée électriquement tout en permettant la dissipation de chaleur souhaitée.

La surface 15 étant anodisée, le radiateur 5 peut venir au contact du circuit imprimé 4 via une couche anodisée, ladite couche ayant par exemple une épaisseur comprise entre 10µm et 30µm tandis que le radiateur a une épaisseur d'environ 2mm.

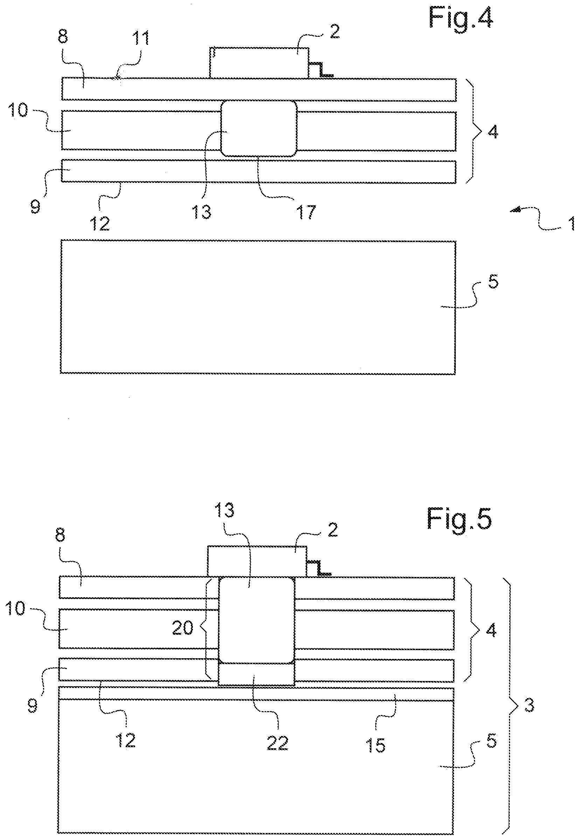

Dans les exemples des figures 3 et 4, qui représentent des variantes de l'ensemble 1 de la figure 2 avant assemblage du circuit imprimé 4 et du radiateur 5, le radiateur ne présente pas de surface anodisée. Dans l'exemple de la figure 3, l'isolation électrique est obtenue en anodisant chacune des faces par lesquelles l'insert 13 vient en regard d'une couche métallique 8 ou 9.

L'insert 13 présente par exemple une face 16 venant en regard de la première couche en cuivre 8 et une face 17 venant en regard de la deuxième couche en cuivre 9 et ces deux faces 16 et 17 sont anodisées. Le cas échéant, les surfaces de contact correspondantes des faces de contact 16 et 17 et qui appartiennent respectivement à la première couche en cuivre 9 et à la deuxième couche en cuivre 10 peuvent également ou à la place être anodisées.

Dans l'exemple de la figure 4, la portion de la surface de réception 11 au contact du composant électronique 2 et la face d'extrémité 12 définie par la deuxième couche en cuivre 9 sont anodisées. Toujours dans l'exemple de la figure 4, le composant électronique 2 peut comprendre un boîtier dont au moins la partie au contact du circuit imprimé 4 est métallique et cette partie métallique du boîtier peut être anodisée.

Dans un autre exemple non représenté, l'ensemble 1 peut présenter toutes les surfaces anodisées recensées dans les exemples des figures 2 à 4.

On va maintenant décrire en référence aux figures 5 à 7 des variantes d'ensemble 1 selon un deuxième mode de mise en oeuvre de l'invention.

Dans ces exemples, une cavité 20 est ménagée à travers les couches 8 à 10 du circuit imprimé 4 et l'insert est monté à force dans cette cavité 20. L'insert 13 est ici reçu dans l'épaisseur de la première couche en cuivre 8 et de la couche en prépreg 10. L'insert 13 contacte par sa face 16 le composant électronique 2. Néanmoins, l'insert n'est pas reçu dans l'épaisseur de la deuxième couche en cuivre 9, de sorte qu'au niveau de celle-ci, la cavité 20 n'est pas occupée par l'insert 13. Le circuit imprimé 4 représenté sur les figures 3 et 4 est par exemple commercialisé par la société Ruwel International™ sous la référence FR4 2LCopper In-LAY

Une résine 22, par exemple un film standard U90 bleu sans colle 2KV / 125°C Keratherm^{R}, est coulée dans la partie de la cavité 20 ménagée dans la deuxième couche en cuivre 9. La résine 22 peut être disposée de manière à ce que la surface d'extrémité 12 reste plane malgré la présence dans la deuxième couche en cuivre 9 de la cavité 20. Le bord inférieur de la résine 22 peut ainsi venir au niveau du reste de la face d'extrémité 12.

Similairement à l'exemple de la figure 2, une surface 15 du radiateur 5 peut être anodisée, cette surface 15 faisant partie du radiateur lorsque ce dernier est monobloc ou appartenant à une pièce rapportée sur une autre partie du radiateur 5 et préalablement anodisée. Le cas échéant, cette anodisation peut être effectuée en profondeur et former une couche d'une épaisseur comprise entre 10µm et 30µm par laquelle le radiateur contacte le circuit imprimé.

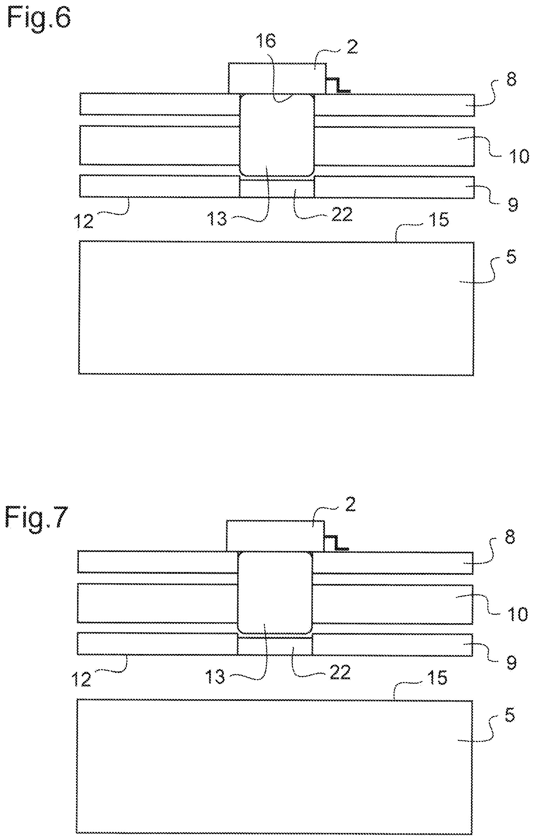

Dans l'exemple des figures 6 et 7 qui représentent des variantes de l'ensemble de la figure 5 avant assemblage du circuit imprimé 4 et du radiateur 5, d'autres moyens pour réaliser l'isolation électrique entre le composant électronique 2 et le radiateur 5 sont présentés.

Dans l'exemple de la figure 6, le radiateur ne présente pas de surface anodisée mais la face 16 de l'insert au contact du composant électronique 2 est anodisée. Lorsque le composant électronique est contenu dans un boîtier qui présente une portion métallique au contact de l'insert 13, ladite portion métallique de ce boîtier peut être anodisée.

Dans l'exemple de la figure 7, l'isolation électrique est procurée par l'anodisation de la face 12 de la deuxième couche en cuivre 9.

Dans un exemple non représenté, l'ensemble 1 peut présenter toutes les surfaces anodisées recensées dans les exemples des figures 5 à 7.

L'invention n'est pas limitée aux exemples qui viennent d'être décrits.

On ne sort pas du cadre de l'invention dès lors que l'on établit, par anodisation d'une ou plusieurs surfaces métalliques, une liaison thermiquement conductrice et électriquement isolante entre le composant électronique 2 et le radiateur 5.

Bien que le terme de « surface anodisée » ait été utilisée, l'invention n'exclut pas que l'anodisation ne se fasse pas seulement en surface mais également en profondeur, c'est-à-dire qu'une portion dont la surface anodisée constitue une extrémité soit également anodisée sur une partie de son épaisseur.

L'expression « comportant un » doit être comprise comme signifiant « comportant au moins un », sauf lorsque le contraire est spécifié.

## Revendications

1. Procédé de réalisation d'une liaison thermiquement conductrice et électriquement isolante entre au moins un composant électronique (2) et un radiateur (5) en tout ou partie métallique, le composant électronique (2) et le radiateur (5) faisant partie d'un ensemble (1) comprenant en outre un circuit imprimé (4) disposé entre le composant électronique (2) et le radiateur (5), une face (11) du circuit imprimé (4) définissant une surface de réception du composant électronique (2), le circuit imprimé (4) comprenant au moins une couche métallique (8, 9) et un insert métallique (13), l'insert métallique (13) étant exclusivement contenu dans la hauteur du circuit imprimé (4),
procédé dans lequel on anodise au moins une surface métallique (11, 12, 15, 16, 17) à travers laquelle la chaleur est dissipée du composant électronique (2) vers le radiateur (5), ladite surface métallique appartenant à l'un du composant électronique (2), du circuit imprimé (4) et du radiateur (5).

2. Procédé selon la revendication 1, dans lequel le composant électronique (2) comprend un boîtier ayant au moins une partie métallique, ledit boîtier reposant sur la surface de réception (11) du circuit imprimé (4) via ladite partie métallique, et dans lequel ladite partie métallique du boîtier est anodisée.

3. Procédé selon la revendication 1 ou 2, dans lequel le radiateur (5) présente une surface (15) en contact avec le circuit imprimé (4) et dans lequel ladite surface (15) du radiateur (5) est anodisée.

4. Procédé selon l'une quelconque des revendications précédentes, dans lequel le circuit imprimé (4) comprend au moins deux couches métalliques (8, 9), la première couche métallique (8) étant interposée entre l'insert métallique (13) et le composant électronique (2) et la deuxième couche métallique (9) étant interposée entre l'insert métallique (13) et le radiateur (5).

5. Procédé selon la revendication 4, dans lequel la surface de réception (11) est définie par une face de la première couche métallique (8) en regard du composant électronique (2), ladite surface de réception (11) étant en tout ou partie anodisée.

6. Procédé selon la revendication 4 ou 5, dans lequel la face (12) de la deuxième couche métallique (9) en regard du radiateur (5) est en tout ou partie anodisée.

7. Procédé selon l'une quelconque des revendications 4 à 6, dans lequel l'insert métallique (13) présente une première face de contact (16) avec une surface de contact correspondante de la première couche métallique (8) et une deuxième face de contact (17) avec une surface de contact correspondante de la deuxième couche métallique (9), et dans lequel on anodise l'une au moins de :
- ladite première face de contact (16),
- ladite surface de contact correspondante de la première couche métallique (8),
- ladite deuxième face de contact (17), et
- ladite surface de contact correspondante de ladite deuxième couche métallique (9).

8. Procédé selon l'une quelconque des revendications 1 à 3, dans lequel l'insert métallique (13) présente une face de contact (16) avec le composant électronique (2) et dans lequel on anodise ladite face de contact (16) de l'insert (13).

9. Procédé selon la revendication 8, dans lequel le circuit imprimé (4) comprend une première (8) et une deuxième (9) couche métallique, et une couche en prépreg (10), une cavité traversante (20) étant ménagée à travers lesdites couches (8, 9, 10), la partie de ladite cavité (20) ménagée dans la deuxième couche métallique (9) étant comblée en tout ou partie par une résine (22).

10. Ensemble (1), comprenant :
- au moins un composant électronique (2),
- un radiateur (5) en tout ou partie métallique et,
- un circuit imprimé (4) disposé entre le radiateur (5) et le composant électronique (2), ledit circuit imprimé (4) ayant une face (11) définissant une surface de réception du composant électronique (2), et ledit circuit imprimé (4) comprenant au moins une couche métallique (8, 9) et un insert métallique (13), l'insert métallique (13) étant exclusivement contenu dans la hauteur du circuit imprimé (4),
l'un au moins du composant électronique (2), du circuit imprimé (4) et du radiateur (5) comprenant au moins une surface métallique (11, 12, 15, 16, 17) à travers laquelle la chaleur dissipée par le composant électronique (2) est transférée vers le radiateur (5), ladite surface métallique étant anodisée.

11. Ensemble selon la revendication 10, l'insert métallique (13) étant réalisé d'une seule pièce.

## Patentansprüche

1. Verfahren zur Herstellung einer thermisch leitenden und elektrisch isolierenden Verbindung zwischen mindestens einem elektronischen Bauteil (2) und einem ganz oder teilweise metallischen Kühlkörper (5), wobei das elektronische Bauteil (2) und der Kühlkörper (5) Teil einer Einheit (1) sind, die außerdem eine Leiterplatte (4) enthält, welche zwischen dem elektronischen Bauteil (2) und dem Kühlkörper (5) angeordnet ist, wobei eine Seite (11) der Leiterplatte (4) eine Aufnahmefläche des elektronischen Bauteils (2) definiert, wobei die Leiterplatte (4) mindestens eine metallische Schicht (8, 9) und einen metallischen Einsatz (13) enthält, wobei der metallische Einsatz (13) ausschließlich in der Höhe der Leiterplatte (4) enthalten ist, Verfahren, bei dem mindestens eine metallische Fläche (11, 12, 15, 16, 17) anodisiert wird, durch die hindurch die Wärme vom elektronischen Bauteil (2) zum Kühlkörper (5) abgeführt wird, wobei die metallische Fläche zu einem von dem elektronischen Bauteil (2), der Leiterplatte (4) und dem Kühlkörper (5) gehört.

2. Verfahren nach Anspruch 1, wobei das elektronische Bauteil (2) ein Gehäuse enthält, das mindestens einen metallischen Teil hat, wobei das Gehäuse auf der Aufnahmefläche (11) der Leiterplatte (4) über den metallischen Teil aufliegt, und wobei der metallische Teil des Gehäuses anodisiert ist.

3. Verfahren nach Anspruch 1 oder 2, wobei der Kühlkörper (5) eine Fläche (15) in Kontakt mit der Leiterplatte (4) aufweist, und wobei die Fläche (15) des Kühlkörpers (5) anodisiert ist.

4. Verfahren nach einem der vorhergehenden Ansprüche, wobei die Leiterplatte (4) mindestens zwei metallische Schichten (8, 9) enthält, wobei die erste metallische Schicht (8) zwischen den metallischen Einsatz (13) und das elektronische Bauteil (2) eingefügt ist, und die zweite metallische Schicht (9) zwischen den metallischen Einsatz (13) und den Kühlkörper (5) eingefügt ist.

5. Verfahren nach Anspruch 4, wobei die Aufnahmefläche (11) durch eine Seite der ersten metallischen Schicht (8) gegenüber dem elektronischen Bauteil (2) definiert wird, wobei die Aufnahmefläche (11) ganz oder teilweise anodisiert ist.

6. Verfahren nach Anspruch 4 oder 5, wobei die Seite (12) der zweiten metallischen Schicht (9) gegenüber dem Kühlkörper (5) ganz oder teilweise anodisiert ist.

7. Verfahren nach einem der Ansprüche 4 bis 6, wobei der metallische Einsatz (13) eine erste Kontaktseite (16) mit einer entsprechenden Kontaktfläche der ersten metallischen Schicht (8) und eine zweite Kontaktseite (17) mit einer entsprechenden Kontaktfläche der zweiten metallischen Schicht (9) aufweist, und wobei mindestens eine anodisiert wird von:
- der ersten Kontaktseite (16),
- der entsprechenden Kontaktfläche der ersten metallischen Schicht (8),
- der zweiten Kontaktseite (17), und
- der entsprechenden Kontaktfläche der zweiten metallischen Schicht (9).

8. Verfahren nach einem der Ansprüche 1 bis 3, wobei der metallische Einsatz (13) eine Kontaktseite (16) mit dem elektronischen Bauteil (2) aufweist, und wobei die Kontaktseite (16) des Einsatzes (13) anodisiert wird.

9. Verfahren nach Anspruch 8, wobei die Leiterplatte (4) eine erste (8) und eine zweite (9) metallische Schicht und eine Schicht aus Prepreg (10) enthält, wobei ein Durchgangshohlraum (20) durch die Schichten (8, 9, 10) hindurch ausgespart ist, wobei der Teil des Hohlraums (20), der in der zweiten metallischen Schicht (9) ausgespart ist, ganz oder teilweise mit einem Harz (22) gefüllt wird.

10. Einheit (1), die enthält:
- mindestens ein elektronisches Bauteil (2),
- einen ganz oder teilweise metallischen Kühlkörper (5), und
- eine Leiterplatte (4), die zwischen dem Kühlkörper (5) und dem elektronischen Bauteil (2) angeordnet ist, wobei die Leiterplatte (4) eine Seite (11) hat, die eine Aufnahmefläche des elektronischen Bauteils (2) definiert, und die Leiterplatte (4) mindestens eine metallische Schicht (8, 9) und einen metallischen Einsatz (13) enthält, wobei der metallische Einsatz (13) ausschließlich in der Höhe der Leiterplatte (4) enthalten ist,
wobei mindestens eines vom elektronischen Bauteil (2), von der Leiterplatte (4) und vom Kühlkörper (5) mindestens eine metallische Fläche (11, 12, 15, 16, 17) enthält, durch die hindurch die vom elektronischen Bauteil (2) abgeführte Wärme zum Kühlkörper (5) übertragen wird, wobei die metallische Fläche anodisiert ist.

11. Einheit nach Anspruch 10, wobei der metallische Einsatz (13) aus einem Stück hergestellt ist.

## Claims

1. Method for producing a thermally conductive and electrically insulating connection between at least one electronic component (2) and a radiator (5) that is entirely or partially made of metal, the electronic component (2) and the radiator (5) forming part of an assembly (1) furthermore comprising a printed circuit board (4) placed between the electronic component (2) and the radiator (5), one face (11) of the printed circuit board (4) defining a surface for receiving the electronic component (2), the printed circuit board (4) comprising at least one metal layer (8, 9) and a metal insert (13), the metal insert (13) being exclusively contained in the height of the printed circuit board (4),
in which method at least one metal surface (11, 12, 15, 16, 17) through which heat is dissipated from the electronic component (2) to the radiator (5) is anodized, said metal surface belonging to one of the electronic component (2), the printed circuit board (4) and the radiator (5).

2. Method according to Claim 1, in which the electronic component (2) comprises a package having at least one metal portion, said package resting on the receiving surface (11) of the printed circuit board (4) via said metal portion, and in which said metal portion of the package is anodized.

3. Method according to Claim 1 or 2, in which the radiator (5) has a surface (15) making contact with the printed circuit board (4) and in which said surface (15) of the radiator (5) is anodized.

4. Method according to any one of the preceding claims, in which the printed circuit board (4) comprises at least two metal layers (8, 9), the first metal layer (8) being interposed between the metal insert (13) and the electronic component (2), and the second metal layer (9) being interposed between the metal insert (13) and the radiator (5).

5. Method according to Claim 4, in which the receiving surface (11) is defined by a face of the first metal layer (8) facing the electronic component (2), said receiving surface (11) being entirely or partially anodized.

6. Method according to Claim 4 or 5, in which the face (12) of the second metal layer (9) facing the radiator (5) is entirely or partially anodized.

7. Method according to any one of Claims 4 to 6, in which the metal insert (13) has a first contact face (16) making contact with a corresponding contact surface of the first metal layer (8), and a second contact face (17) making contact with a corresponding contact surface of the second metal layer (9), and in which at least one of the following is anodized:
- said first contact face (16),
- said corresponding contact surface of the first metal layer (8),
- said second contact face (17), and
- said corresponding contact surface of said second metal layer (9).

8. Method according to any one of Claims 1 to 3, in which the metal insert (13) has a contact face (16) making contact with the electronic component (2), and in which said contact face (16) of the insert (13) is anodized.

9. Method according to Claim 8, in which the printed circuit board (4) comprises a first metal layer (8), a second metal layer (9) and a prepreg layer (10), a through-cavity (20) being produced through said layers (8, 9, 10), the portion of said cavity (20) produced in the second metal layer (9) being entirely or partially filled with a resin (22).

10. Assembly (1) comprising:
- at least one electronic component (2),
- a radiator (5) that is entirely or partially made of metal, and
- a printed circuit board (4) placed between the radiator (5) and the electronic component (2), said printed circuit board (4) having a face (11) defining a surface for receiving the electronic component (2), and said printed circuit board (4) comprising at least one metal layer (8, 9) and a metal insert (13), the metal insert (13) being exclusively contained in the height of the printed circuit board (4),
one at least of the electronic component (2), the printed circuit board (4) and the radiator (5) comprising at least one metal surface (11, 12, 15, 16, 17) through which heat dissipated by the electronic component (2) is transferred to the radiator (5), said metal surface being anodized.

11. Assembly according to Claim 10, the metal insert (13) being made of a single part.
